# EUROPÄISCHE PATENTSCHRIFT

(11) **EP 1 734 582 B1**
(45) Veröffentlichungstag und Bekanntmachung des Hinweises auf die Patenterteilung: **16.04.2008**
(21) Anmeldenummer: 06011800.7
(22) Anmeldetag: 08.06.2006
(51) Int. Cl.: H01L 27/12, H01L 21/84

(54) **Integrierter Schaltkreis und Verfahren zur Herstellung eines integrierten Schaltkreises**
Integrated circuit and method for manufacturing an integrated circuit
Circuit intégré et méthode pour fabriquer un circuit intégré

(30) Priorität: 14.06.2005 DE 102005027369
(43) Veröffentlichungstag der Anmeldung: 20.12.2006
(73) Patentinhaber: ATMEL Germany GmbH, 74072 Heilbronn (DE)
(72) Erfinder: Dudek, Volker, Dr., 74336 Brackenheim (DE); Graf, Michael, Dr., 71397 Leutenbach (DE); Heid, Andre, 71672 Marbach (DE); Schwantes, Stefan, Dr., 74080 Heilbronn (DE)
(74) Vertreter: Müller, Wolf-Christian

(56) Entgegenhaltungen:
- EP-A- 0 810 652
- US-A- 5 485 030
- US-A- 5 939 755
- US-A1- 2004 119 132
- PATENT ABSTRACTS OF JAPAN Bd. 2003, Nr. 09, 3. September 2003 (2003-09-03) -& JP 2003 142575 A (HITACHI LTD), 16. Mai 2003 (2003-05-16)
- PATENT ABSTRACTS OF JAPAN Bd. 2002, Nr. 07, 3. Juli 2002 (2002-07-03) -& JP 2002 083935 A (NISSAN MOTOR CO LTD), 22. März 2002 (2002-03-22)
- PATENT ABSTRACTS OF JAPAN Bd. 1997, Nr. 03, 31. März 1997 (1997-03-31) -& JP 08 306893 A (NIPPONDENSO CO LTD), 22. November 1996 (1996-11-22)

## Beschreibung

Die vorliegende Erfindung betrifft einen integrierten Schaltkreis und ein Verfahren zur Herstellung eines integrierten Schaltkreises.

In so genannten Smart-Power-Schaltkreisen werden DMOS-Transistoren mit hohen Sperrspannungen, von beispielsweise 80 Volt und geringen Einschaltwiderständen von wenigen Milliohm verwendet. Zusätzlich sind in den Smart-Power-Schaltkreisen analoge und/oder digitale Schaltkreise zur Signalauswertung und Steuerung vorgesehen. Von den DMOS-Transistoren werden sowohl der N-Typ (NDMOS-Transistor) als auch der P-Typ (PDMOS-Transistor) verwendet, wie beispielsweise der JP-A-20033142575 und der JP-A-08306893 bekannt ist.

Eine erste Aufgabe der vorliegenden Erfindung ist es, einen integrierten Schaltkreis mit einem NDMOS-Transistor und einem PDMOS-Transistor weiter zu entwickeln. Eine zweite Aufgabe der vorliegenden Erfindung ist es, ein Verfahren zur Herstellung eines integrierten Schaltkreises mit einem NDMOS-Transistor und einem PDMOS-Transistor weiter zu entwickeln.

Die erste Aufgabe wird durch die Merkmale des unabhängigen Vorrichtungsanspruchs gelöst. Die zweite Aufgabe wird jeweils durch die Merkmale der unabhängigen Verfahrensansprüche gelöst. Vorteilhafte Weiterbildungen der Erfindung sind Gegenstand von Unteransprüchen.

Demzufolge ist zur Lösung der ersten Aufgabe gemäß dem unabhängigen Vorrichtungsanspruch ein integrierter Schaltkreis vorgesehen. Dieser integrierte Schaltkreis weist einen Bauelementebereich mit zumindest einem NDMOS-Transistor und zumindest einem PDMOS-Transistor auf. Der Bauelementebereich weist daher Halbleitergebiete, beispielsweise aus Silizium auf, die durch Strukturierung und Dotierung vorzugsweise als Source-Halbleitergebiet, Drain-Halbleitergebiet, sowie als Body-Halbleitergebiet und/oder als Driftzone ausgebildet sind. DMOS-Transistoren sind Feldeffekttransistoren, die beispielsweise zum Schalten oder Steuern von Lastströmen für Betriebsspannungen von beispielsweise größer 42 Volt ausgebildet sind. Der PDMOS-Transistor weist dabei ein p-dotiertes Source-Halbleitergebiet und eine p-dotiertes Drain-Halbleitergebiet auf, während der NDMOS-Transistor ein n-dotiertes Source-Halbleitergebiet und ein n-dotiertes Drain-Halbleitergebiet aufweist.

Weiterhin weist der integrierte Schaltkreis ein Substrat auf, das von dem Bauelementebereich durch ein Dielektrikum isoliert ist. Derartige vom Bauelementebereich isolierte Substrate werden auch als SOI (semiconductor on insulator) bezeichnet.

Der Bauelementebereich, das Dielektrikum und das Substrat bilden eine erste, auf eine Flächeneinheit normierte Substratkapazität in einem ersten Bereich des PDMOS-Transistors und eine zweite, auf diese Flächeneinheit normierte Substratkapazität in einem zweiten Bereich des NDMOS-Transistors aus. Eine Flächeneinheit, auf die die Substratkapazitäten normiert sind, ist beispielsweise 0,1µm², 1µm² oder 10µm². Durch diese Normierung ist sind die Substratkapazitäten daher maßgeblich von der Dicke des Dielektrikums und/oder der Dielektrizitätszahl (µᵣ) abhängig.

Die erste, auf diese Flächeneinheit normierte Substratkapazität ist gegenüber der zweiten, auf diese Flächeneinheit normierte Substratkapazität reduziert.

Zwar ist es möglich, die erste Substratkapazität gegenüber der zweiten Substratkapazität durch die Verwendung eines anderen Dielektrikummaterials mit einer anderen Dielektrizitätszahl zu reduzieren, jedoch ist in einer ersten besonders vorteilhaften Weiterbildung der Erfindung vorgesehen, dass die erste, auf die Flächeneinheit normierte Substratkapazität gegenüber der zweiten auf die Flächeneinheit normierte Substratkapazität reduziert ist, indem das Dielektrikum in dem ersten Bereich des PDMOS-Transistors eine größere erste Dicke gegenüber einer zweiten Dicke des Dielektrikums in dem zweiten Bereich des NDMOS-Transistors aufweist.

In einer vorteilhaften Ausgestaltung dieser Weiterbildung ist vorgesehen, dass eine Breite des ersten Bereichs größer ist als die erste Dicke des Dielektrikums in diesem ersten Bereich. Vorzugsweise erstreckt sich dabei die Breite des erste Bereichs über einen Übergangsbereich zwischen dem n-dotierten Body und der p-dotierten Driftzone des PDMOS-Transistors.

Gemäß einer anderen Weiterbildungsvariante der Erfindung ist die erste, auf die Flächeneinheit normierte Substratkapazität gegenüber der zweiten auf die Flächeneinheit normierte Substratkapazität reduziert, indem das Substrat in dem ersten Bereich des PDMOS-Transistors lokal entfernt ist. In diesem ersten Bereich fehlt demzufolge das Substrat, während es im zweiten Bereich des NDMOS-Transistors verbleibt und dort vorteilhafterweise als Substratelektrode wirkt.

In einer vorteilhaften Ausgestaltung dieser Weiterbildungsvariante ist der erste Bereich ein Übergangsbereich einer N-Wanne und einer P-Wanne des PDMOS-Transistors. Bei angelegter Betriebsspannung definiert die P-Wanne vorzugsweise eine Driftzone, während die N-Wanne den Body definiert. Der Body kann beispielsweise über einen hoch n-dotierten Halbleiterbereich an ein gewünschtes Potential angeschlossen werden.

Gemäß einer bevorzugten Weiterbildung der Erfindung sind in dem ersten Bereich eine Mehrzahl von PDMOS-Transistoren und/oder in dem zweiten Bereich eine Mehrzahl von NDMOS-Transistoren ausgebildet. Die PDMOS-Transistoren sind vorteilhafterweise in dem ersten Bereich durch spezifische Designregeln örtlich beieinander gruppiert. Gleiches gilt für die NDMOS-Transistoren, die vorteilhafterweise in dem zweiten Bereich örtlich beieinander gruppiert sind. Bevorzugt ist der erste Bereich von NDMOS-Transistoren beabstandet.

Die Verfahrensaufgabe wird durch die folgenden beiden Erfindungsvarianten gelöst.

In einer ersten Variante ist ein Verfahren zur Herstellung eines integrierten Schaltkreises vorgesehen, indem ein Substrat, ein an das Substrat grenzendes Dielektrikum und ein an das Dielektrikum grenzendes Halbleitergebiet erzeugt werden. Zur Erzeugung können beispielsweise zwei Siliziumwafer aufeinander gebondet werden, wobei zumindest ein Wafer als Bondfläche eine Siliziumdioxidschicht aufweist. Das Halbleitergebiet des einen Wafers kann nachfolgend gedünnt werden.

In dem Halbleitergebiet werden zumindest ein NDMOS-Transistor und eine PDMOS-Transistor ausgebildet. Zur Ausbildung der Transistoren wird das Halbleitergebiet strukturiert und entsprechend des Typs des Transistors dotiert.

Zur Erzeugung des Dielektrikums wird dieses in einem ersten Bereich des PDMOS-Transistors dicker ausgebildet als in einem zweiten Bereich des NDMOS-Transistors. Die Ausbildung des Dielektrikum erfolgt dabei vorzugsweise zeitlich vor der Ausbildung der Transistorstrukturen.

In einer zweiten Variante ist ein Verfahren zur Herstellung eines integrierten Schaltkreises vorgesehen, indem ein, an einem Substrat angrenzendes Dielektrikum und ein durch das Dielektrikum vom Substrat isoliertes Halbleitergebiet erzeugt werden.

In dem Halbleitergebiet werden zumindest ein NDMOS-Transistor und ein PDMOS-Transistor ausgebildet. Zur Ausbildung der Transistoren wird das Halbleitergebiet strukturiert und entsprechend des Typs des Transistors dotiert.

In einem ersten Bereich unterhalb des PDMOS-Transistors wird das Substrat lokal, insbesondere durch Ätzung, entfernt. Zur lokalen Ätzung wird das Substrat beispielsweise mit einer Ätzmaskierung bedeckt, die lediglich das Substrat innerhalb des ersten Bereiches für einen Ätzangriff freilässt. Die Ätzung kann dabei vor oder nach der Ausbildung des PDMOS-Transistors erfolgen.

Im Folgenden wird die Erfindung in Ausführungsbeispielen anhand von Zeichnungen näher erläutert. Dabei zeigen
- Fig. 1: eine schematische Draufsicht auf einen integrierten Schaltkreis,
- Fig. 2: eine schematische Schnittansicht eines ersten Ausführungsbeispiels,
- Fig. 3: eine schematische Schnittansicht eines zweiten Ausführungsbeispiels,
- Fig. 4: eine erste schematische Schnittansicht nach einem Prozessschritt einer Herstellung eines integrierten Schaltkreises, und
- Fig. 5: eine zweite schematische Schnittansicht nach einem Prozessschritt einer Herstellung eines integrierten Schaltkreises.

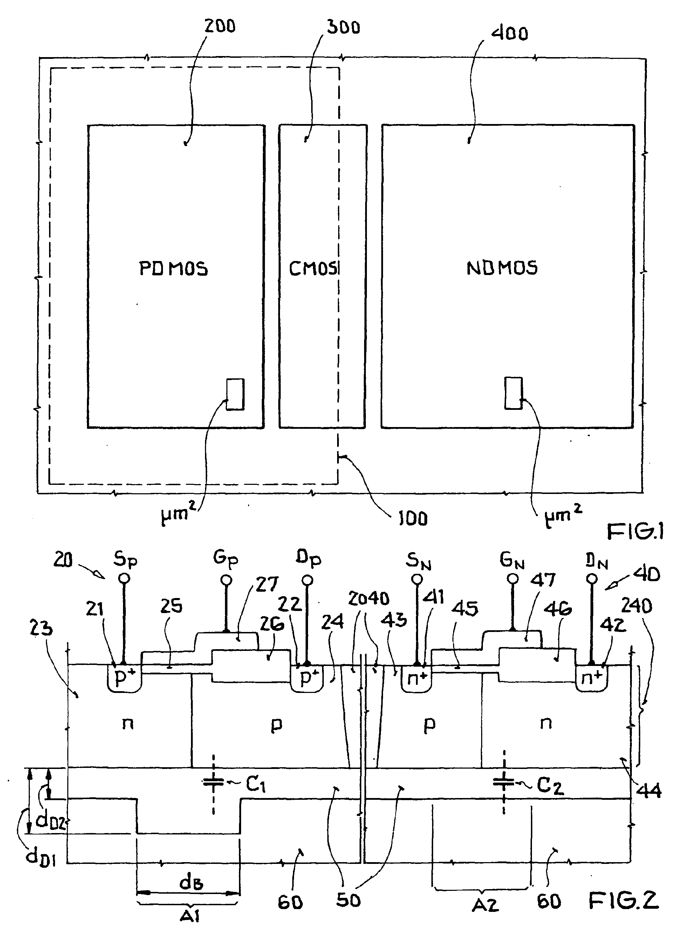

In Fig. 1 sind in einer schematischen Draufsicht mehrere Bereiches 200, 300, 400 eines integrierten Schaltkreises dargestellt. In einem ersten Bereich 200 sind eine Mehrzahl von PDMOS-Transistoren angeordnet. In einem zweiten Bereich 400 sind eine Mehrzahl von NDMOS-Transistoren angeordnet. Zwischen diesem ersten Bereich 200 und diesem zweiten Bereich 400 ist ein dritter Bereich 300 mit analogen und/oder digitalen CMOS-Strukturen angeordnet, die mit den PDMOS-Transistoren und/oder den NDMOS-Transistoren in dem integrierten Schaltkreis zusammenwirken. Derartige integrierte Strukturen, die sowohl Leistungshalbleiter (PDMOS/NDMOS) als auch Niederleistungs-CMOS-Strukturen zur Auswertung und Steuerung aufweisen, werden auch als Smart-Power-Schaltkreise bezeichnet.

Weiterhin ist in Fig. 1 eine normierte Flächeneinheit von 1 µm² im ersten Bereich 200 als auch im zweiten Bereich 400 schematisch dargestellt. Im Ausführungsbeispiel der Fig. 1 sind sowohl die PDMOS-Transistoren als auch die NDMOS-Transistoren gegenüber einem (in Fig. 1 nicht dargestellten) Substrat durch ein (in Fig. 1 nicht dargestelltes) Dielektrikum isoliert. Um eine Substratkapazität der PDMOS-Transistoren gegenüber dem Substrat zu reduzieren, ist unterhalb der PDMOS-Transistoren, in einem vierten Bereich 100 das Substrat entfernt. In dem Ausführungsbeispiel der Fig. 1 ist der vierte Bereich 100 dabei größer als der erste Bereich 200 und schließt diesen ersten Bereich 200 vollständig ein. Der vierte Bereich 100 ist zudem von dem zweiten Bereich 400 mit den NDMOS-Transistoren beabstandet. In dem Ausführungsbeispiel der Fig. 1 sind sämtliche PDMOS-Transistoren innerhalb des ersten Bereichs 200 örtlich zusammengelegt. Ebenso sind sämtliche NDMOS-Transistoren im zweiten Bereich 400 angeordnet und über in Fig. 1 nicht dargestellte Metallisierungsebenen mit dem ersten Bereich 200 und/oder dem dritten Bereich 300 verbunden.

Fig. 2 zeigt einen integrierten Schaltkreis, der einen Bauelementebereich 240 mit einem NDMOS-Transistor 40 und einem PDMOS-Transistor 20 aufweist. Weiterhin weist der integrierte Schaltkreis ein Substrat 60 auf, das von dem Bauelementebereich 240 durch ein vergrabenes Dielektrikum 50 isoliert ist. In einem ersten Bereich A₁ des PDMOS-Transistor 20 ist das Dielektrikum 50 mit einer größeren ersten Dicke d_{D1} gegenüber einer zweiten, kleineren Dicke d_{D2} des Dielektrikums 50 in einem zweiten Bereich A₂ des NDMOS-Transistors 40 ausgebildet.

Dieser Aufbau bewirkt vorteilhafterweise eine erste kleinere Kapazität C₁ zwischen dem ersten Bereich A₁ des PDMOS-Transistors 20 und dem Substrat 60 gegenüber einer zweiten, größeren Kapazität C₂ zwischen dem zweiten Bereich A₂ des NDMOS-Transistors 40 und dem Substrat 60. Das Substrat 60 ist vorzugsweise aus Silizium. Im Ausführungsbeispiel der Fig. 2 ist der erste Bereich A₁ ein erster Übergangsbereich zwischen einer P-Wanne 24 und einer N-Wanne 23 des PDMOS-Transistors 20. Der zweite Bereich A₂ ist beispielsweise ein zweiter Übergangsbereich zwischen einer N-Wanne 44 und einer P-Wanne 43 des NDMOS-Transistors 40.

In dem Ausführungsbeispiel der Fig. 2 sind der PDMOS-Transistor 20 und der NDMOS-Transistor 40 durch einen mit einem weiteren Dielektrikum verfüllten Graben 2040 voneinander isoliert.

Im Folgenden wird der Aufbau des PDMOS-Transistors 20 und des NDMOS-Transistors 40 kurz beschrieben. Der dargestellte Aufbau ist als bevorzugtes Ausführungsbeispiel für einen PDMOS-Transistor 20 beziehungsweise einen NDMOS-Transistor 40 schematisch skizziert.

Der PDMOS-Transistor 20 weist einen Source-Anschluss S_{P} (Quelle) einen Gate-Anschluss G_{P} (Tor) und einen Drain-Anschluss D_{P} (Senke) auf. Der Source-Anschluss S_{P} ist mit einem hoch p-dotierten Source-Halbleitergebiet 21 verbunden. Dieses Source-Halbleitergebiet 21 ist durch Implantation innerhalb einer N-Wanne 23 des PDMOS-Tranisstors 20 angeordnet. Der Drain-Anschluss D_{P} ist mit einem hoch p-dotierten Drain-Halbleitergebiet 22 verbunden, das durch Implantation in einer P-Wanne 24 des PDMOS-Transistors 20 angeordnet ist. Die N-Wanne 23 und die P-Wanne 24 grenzen unterhalb eines Gate-Oxids 25 aneinander. Der Gate-Anschluss G_{P} ist mit einer Gate-Elektrode 27 verbunden, die beispielsweise aus polykristallinem Silizium ausgebildet ist. Die Gate-Elektrode 27 ist dabei auf dem Gate-Oxid 25 und teilweise auf einem Feldoxid 26 angeordnet.

Der NDMOS-Transistor 40 weist einen Source-Anschluss S_{N} (Quelle) einen Gate-Anschluss G_{N} (Tor) und einen Drain-Anschluss D_{N} (Senke) auf. Der Source-Anschluss S_{N} ist mit einem hoch n-dotierten Source-Halbleitergebiet 41 verbunden. Dieses Source-Halbleitergebiet 41 ist durch Implantation innerhalb einer P-Wanne 43 des NDMOS-Transistors 40 angeordnet. Der Drain-Anschluss D_{N} ist mit einem hoch n-dotierten Drain-Halbleitergebiet 42 verbunden, das durch Implantation in einer N-Wanne 44 des NDMOS-Transistors 40 angeordnet ist. Die P-Wanne 43 und die N-Wanne 44 grenzen unterhalb eines Gate-Oxids 45 aneinander. Der Gate-Anschluss G_{N} ist mit einer Gate-Elektrode 47 verbunden, die beispielsweise aus polykristallinem Silizium ausgebildet ist. Die Gate-Elektrode 47 ist dabei auf dem Gate-Oxid 45 und teilweise auf einem Feldoxid 46 angeordnet.

Im Bereich A₂ des NDMOS-Transistors 40 wirkt das vergrabene Dielektrikum 50 zusammen mit dem Substrat 60 wie eine zusätzliche Gate-Elektrode. Die Dicke d_{D2} des vergrabenen Dielektrikums 50, beispielsweise eines Siliziumdioxids, beeinflusst dabei die Durchbruchspannung des NDMOS-Transistors 40. Der NDMOS-Transistor 40 weist eine größte Drain-seitige Durchbruchspannung bei etwa 500 nm auf. Der PDMOS-Transistor weist seine größte Drain-seitige Durchbruchspannung hingegen bei mindestens 1000nm, vorzugsweise 2000nm Dielektrikumdicke d_{D1} auf. Der NDMOS-Transistor 40 profitiert dabei von der Verarmungsladung in der Driftzone, die durch die Siliziumsubstratelektrode 60 induziert wird (RESURF Effekt). Ein zu dickes vergrabenes Dielektrikum 50 schwächt diesen positiven Effekt ab.

Der PDMOS-Transistor 20 hingegen kann aufgrund der anderen Ladungsträgerpolarität nicht von dem RESURF-Effekt profitieren. Der Großteil der Verarmungsladung wird hier in der N-Wanne 23 und nicht in der Driftzone, die sich insbesondere in der P-Wanne 24 ausbildet, induziert. Die durch die Substratelektrode 60 induzierte Verarmungsladung in der N-Wanne 23 hat jedoch einen schädlichen Effekt auf die Durchbruchspannung des Drains des PDMOS-Transistors 20. Durch die Vergrößerung auf die Dicke d_{D1} des vergrabenen Dielektrikums 50 im ersten Bereich A₁ beim PDMOS-Transistor 20 wird dieser Effekt der Verarmungsladung im ersten Bereich A₁ reduziert. Hierzu ist, wie in Fig. 2 dargestellt, unterhalb des Übergangs von der n-dotierten N-Wanne 23 zur p-dotierten P-Wanne 24 die Dicke d_{D1} des Dielektrikums 50 lokal vergrößert. Die Dicke d_{D1} des Dielektrikums 50 beträgt in diesem ersten Bereich A₁ vorzugsweise mindestens 1000nm. Die Ausdehnung d_{B} des ersten Bereichs A₁ beträgt vorzugsweise mindestens 7 µm.

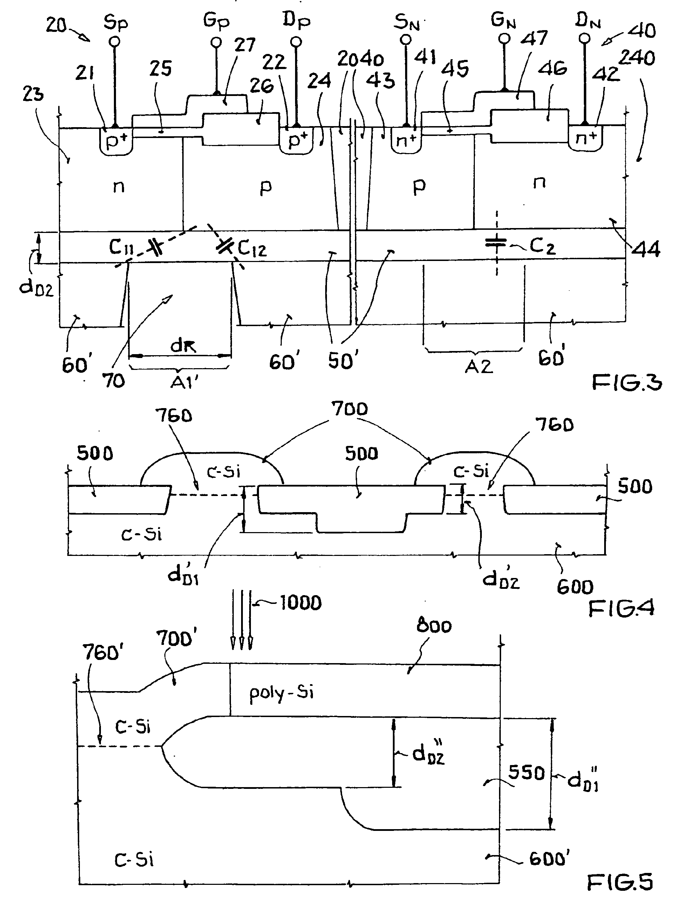

Unterschiedliche Herstellungsmöglichkeiten für verschiedene Dielektrikumdicken sind in den Figuren 4 und 5 schematisch dargestellt. In Fig. 4 wird zunächst, das Dielektrikum 500 beispielsweise durch Oxidation oder Implantation von Sauerstoff mit einer ersten Dicke d_{D1}' und mit einer zweiten geringeren Dicke d_{D2}' auf dem Substrat 600 erzeugt. Ausgehend von Saatfenstern 760 als Kristallisationskeim wird eine amorphe Siliziumschicht zu monokristallinem Silizium 700 (c-Si) kristallisiert und so die Dielektrikagebiete 500 zwischen den Saatfenstern 760 durch monokristallines Silizium 700 zumindest teilweise überwachsen.

Eine andere Möglichkeit zeigt Fig. 5. Dabei wird wiederum ausgehend von einem, als Kristallisationskeim wirkenden Saatfenster 760' polykristallines Silizium 800 durch den lokalen Energieeintrag eines Laserstrahles 1000 zu monokristallinem Silizium 700' rekristallisiert. Die unterschiedlichen Dicken d_{D1}", d_{D2}" des Dielektrikums 550 wurden zuvor auf dem Substrat 600' ausgebildet.

Alternativ zur Vergrößerung der Dielektrikumdicke kann, wie in Fig. 3 dargestellt, das Substrat unterhalb des vergrabenen Dielektrikums 50' in einem ersten Bereich A1' entfernt werden. Fig. 3 zeigt daher einen Integrierten Schaltkreis, der einen Bauelementebereich 240 mit einem NDMOS-Transistor 40 und einem PDMOS-Transistor 20 aufweist. Weiterhin weist der integrierte Schaltkreis ein Substrat 60' auf, das von dem Bauelementebereich 240 durch ein vergrabenes Dielektrikum 50' isoliert ist. In einem ersten Bereich A1 des PDMOS-Transistors 20 ist das Substrat 60' in dem ersten Bereich A1' des PDMOS-Transistors 20 entfernt.

In dem Übergangsbereich zwischen P-Wanne 24 und N-Wanne 23 ist das Substrat 60' vorzugsweise auf eine Breite d_{R} entfernt, die vorteilhafterweise breiter ist als die Dicke d_{D2} des Dielektrikums 50'. Das Substrat 60' kann beispielsweise mittels einer KOH-Ätzung entfernt werden. Dies führt zu einer weitgehenden Reduzierung des negativen Einflusses der Siliziumsubstratelektrode 60' auf den PDMOS-Transistor 20. Vorteilhafterweise ist vor der KOH-Ätzung das Substrat 60' auf eine Dicke von 200nm gedünnt worden.

Der durch die KOH-Ätzung im Substrat 60' entstehende Substrat-Graben 70 kann, wie in Fig. 3 dargestellt, freigelassen werden oder alternativ durch ein weiteres Dielektrikum verfüllt werden. Die verbleibenden (parasitären) Kapazitäten C₁₁ und C₁₂ zu dem außerhalb des Substrat-Grabens 70 verbleibenden Substrat 60' sind dabei signifikant geringer als die Kapazität C₂. Der erste Bereich A₁', in dem das Substrat 60' entfernt ist, kann anders als in Fig. 3 dargestellt, größere Ausmaße, insbesondere die Grundfläche (200, siehe Fig. 1) aller PDMOS-Transistoren (20) umfassen.

## Patentansprüche

1. Integrierter Schaltkreis mit
- einem Bauelementebereich (240) mit zumindest einem NDMOS-Transistor (40) und zumindest einem PDMOS-Transistor (20) und
- einem Substrat (60, 60', 600, 600'), das von dem Bauelementebereich (240) durch ein Dielektrikum (50, 50', 500, 550) isoliert ist,
wobei der Bauelementebereich (240), das Dielektrikum (50, 50', 500, 550) und das Substrat (60, 60', 600, 600') eine erste, auf eine Flächeneinheit (µm²) normierte Substratkapazität (C₁, C₁₁, C₁₂) in einem ersten Bereich (A₁, A₁', 200) des PDMOS-Transistors (20) und eine zweite, auf diese Flächeneinheit (µm²) normierte Substratkapazität (C₂) in einem zweiten Bereich (A₂, 400) des NDMOS-Transistors (40) ausbilden, **dadurch gekennzeichnet, daß**
die erste, auf diese Flächeneinheit (µm²) normierte Substratkapazität (C₁, C₁₁, C₁₂) gegenüber der zweiten, auf diese Flächeneinheit (µm²) normierte Substratkapazität (C₂) reduziert ist.

2. Integrierter Schaltkreis nach Anspruch 1, bei dem
die erste, auf die Flächeneinheit (µm²) normierte Substratkapazität (C₁) gegenüber der zweiten, auf die Flächeneinheit (µm²) normierte Substratkapazität (C₂) durch eine größere erste Dicke (d_{D1}, d_{D1}', d_{D1}") des Dielektrikums (50, 500, 550) in dem ersten Bereich (A₁) des PDMOS-Transistors (20) gegenüber einer zweiten Dicke (d_{D2}, d_{D2}', d_{D2}") des Dielektrikums (50, 500, 550) in dem zweiten Bereich (A₂) des NDMOS-Transistors (40) reduziert ist.

3. Integrierter Schaltkreis nach Anspruch 2, bei dem
eine Breite (d_{B}) des ersten Bereichs (A₁) größer ist als die erste Dicke (d_{D1}, d_{D1}', d_{D1}") des Dielektrikums (50, 500, 550) in diesem ersten Bereich (A₁).

4. Integrierter Schaltkreis zumindest nach Anspruch 1, bei dem
die erste, auf die Flächeneinheit (µm²) normierte Substratkapazität (C₁₁, C₁₂) gegenüber der zweiten auf die Flächeneinheit (µm²) normierte Substratkapazität (C₂) reduziert ist, indem das Substrat (60') in dem ersten Bereich (A₁') des PDMOS-Transistors (20) entfernt ist.

5. Integrierter Schaltkreis nach einem der vorhergehenden Ansprüche, bei dem der erste Bereich (A₁, A₁') ein Übergangsbereich einer N-Wanne (23) und einer P-Wanne (24) des PDMOS-Transistors (20) ist.

6. Integrierter Schaltkreis nach einem der vorhergehenden Ansprüche, bei dem in dem ersten Bereich (200) eine Mehrzahl von PDMOS-Transistoren (20) und/oder in dem zweiten Bereich (400) eine Mehrzahl von NDMOS-Transistoren ausgebildet ist.

7. Integrierter Schaltkreis nach einem der vorhergehenden Ansprüche, bei dem der erste Bereich (A₁, A₁', 200) von jedem NDMOS-Transistor (40) beabstandet ist.

8. Verfahren zur Herstellung eines integrierten Schaltkreises, indem
- ein Substrat (60, 600, 600'), ein an das Substrat (60, 600, 600') grenzendes Dielektrikum (50, 500, 550) und ein an das Dielektrikum (50, 500, 550) grenzendes Halbleitergebiet (700, 700', 800) erzeugt werden,
- in dem Halbleitergebiet (700, 700', 800) zumindest ein NDMOS-Transistor (40) ausgebildet wird,
- in dem Halbleitergebiet (700, 700', 800) zumindest ein PDMOS-Transistor (20) ausgebildet wird,
**dadurch gekennzeichnet, daß**
- das zur Erzeugung des Dielektrikums (50, 500, 550) dieses in einem ersten Bereich (A₁) des PDMOS-Transistors (20) dicker ausgebildet wird als in einem zweiten Bereich (A₂) des NDMOS-Transistors (40).

9. Verfahren zur Herstellung eines integrierten Schaltkreises, indem
- ein, an einem Substrat (60') angrenzendes Dielektrikum (50') und ein durch das Dielektrikum (50') vom Substrat (60') isoliertes Halbleitergebiet erzeugt werden,
- in dem Halbleitergebiet zumindest ein NDMOS-Transistor (40) ausgebildet wird,
- in dem Halbleitergebiet zumindest ein PDMOS-Transistor (20) ausgebildet wird,
**dadurch gekennzeichnet, daß**
- in einem ersten Bereich (A₁') unterhalb des PDMOS-Transistors das Substrat (60') lokal, insbesondere durch Ätzung, entfernt wird.

## Claims

1. Integrated circuit with
- a component region (240) with at least one NDMOS transistor (40) and at least one PDMOS transistor (20) and
- a substrate (60, 60', 600, 600') which is insulated from the component region (240) by a dielectric (50, 50', 500, 550),
wherein the component region (240), the dielectric (50, 50', 500, 550) and the substrate (60, 60', 600, 600') form a first substrate capacitance (C₁, C₁₁, C₁₂), which is standardised to a unit of area (µm²), in a first region (A₁, A₁', 200) of the PDMOS transistor (20) and a second substrate capacitance (C₂), which is standardised to this unit of area (µm²), in a second region (A₂, 400) of the NDMOS transistor (40), **characterised in that** the first substrate capacitance (C₁, C₁₁, C₁₂) standardised to this unit of area (µm²) is reduced relative to the second substrate capacitance (C₂) standardised to this unit of area (µm²).

2. Integrated circuit according to claim 1, in which the first substrate capacitance (C₁) standardised to the unit of area (µm²) is reduced relative to the second substrate capacitance (C₂), which is standardised to the unit of area (µm²), by a greater first thickness (d_{D1}, d_{D1}', d_{D1}") of the dielectric (50, 500, 550) in the first region (A₁) of the PDMOS transistor (20) relative to a second thickness (d_{D2}, d_{D2}', d_{D2}") of the dielectric (50, 500, 550) in the second region (A₂) of the NDOMS transistor (40).

3. Integrated circuit according to claim 2, in which a width (d_{B}) of the first region (A₁) is greater than the first thickness (d_{D1}, d_{D1}', d_{D1}") of the dielectric (50, 500, 550) in this first region (A₁).

4. Integrated circuit at least according to claim 1, in which the first substrate capacitance (C₁₁, C₁₂) standardised to the unit of area (µm²) is reduced relative to the second substrate capacitance (C₂) standardised to the unit of area (µm²) in that the substrate (60') is removed in the first region (A₁') of the PDMOS transistor (20).

5. Integrated circuit according to one of the preceding claims, in which the first region (A₁, A₁') is a transition region of an N trough (23) and of a P trough (24) of the PDMOS transistor (20).

6. Integrated circuit according to one of the preceding claims, in which a plurality of PDMOS transistors (20) is formed in the first region (200) and/or a plurality of NDMOS transistors is formed in the second region (400).

7. Integrated circuit according to one of the preceding claims, in which the first region (A₁, A₁', 200) is spaced from each NDMOS transistor (40).

8. Method of producing an integrated circuit, in that
- a substrate (60, 600, 600'), a dielectric (50, 500, 550) adjoining the substrate (60, 600, 600') and a semiconductor region (700, 700', 800) adjoining the dielectric (50, 500, 550) are produced,
- at least one NDMOS transistor (40) is formed in the semiconductor region (700, 700', 800) and
- at least one PDMOS transistor (20) is formed in the semiconductor region (700, 700', 800),
**characterised in that**
- for producing the dielectric (50, 500, 550) this is formed to be thicker in a first region (A₁) of the PDMOS transistor (20) than in a second region (A₂) of the NDMOS transistor (40).

9. Method of producing an integrated circuit, in that
- a dielectric (50') adjoining a substrate (60') and a semiconductor region insulated by the dielectric (50') from the substrate (60') are produced,
- at least one NDMOS transistor (40) is formed in the semiconductor region and
- at least one PDMOS transistor (20) is formed in the semiconductor region,
**characterised in that**
- the substrate (60') is locally removed, particularly by etching, in a first region (A₁') below the PDMOS transistor.

## Revendications

1. Circuit intégré comprenant :
• une zone de composants (240) comportant au moins un transistor NDMOS (semi-conducteur à oxyde métallique et double diffusion de type n) (40) et au moins un transistor PDMOS (semi-conducteur à oxyde métallique et double diffusion de type p) (20) et
• un substrat (60, 60', 600, 600') isolé de la zone de composants (240) par un diélectrique (50, 50', 500, 550),
la zone de composants (240), le diélectrique (50, 50', 500, 550), et le substrat (60, 60', 600, 600') formant une première capacité de substrat (C₁, C₁₁, C₁₂) normée sur une unité de surface (µm²) dans une première zone (A₁, A₁', 200) du transistor PDMOS (20) et une deuxième capacité de substrat (C₂) normée sur cette unité de surface (µm²) dans une deuxième zone (A₂, 400) du transistor NDMOS (40), **caractérisé en ce que** :
la première capacité de substrat (C₁, C₁₁, C₁₂) normée sur cette unité de surface (µm²) est réduite par rapport à la deuxième capacité de substrat (C₂) normée sur cette unité de surface (µm²).

2. Circuit intégré selon la revendication 1, dans lequel la première capacité de substrat (C₁) normée sur l'unité de surface (µm²) est réduite par rapport à la deuxième capacité de substrat (C₂) normée sur l'unité de surface (µm²) par une première épaisseur (dD₁, dD₁', dD₁") du diélectrique (50, 500, 550) dans la première zone (A1) du transistor PDMOS (20) plus importante par rapport à une deuxième épaisseur (dD₂, dD₂', dD₂") du diélectrique (50, 500, 550) dans la deuxième zone (A₂) du transistor NDMOS (40).

3. Circuit intégré selon la revendication 2, dans lequel une largeur (d_{B}) de la première zone (A₁) est supérieure à la première épaisseur (d_{D1}, d_{D1}', d_{D1}") du diélectrique (50, 500, 550) dans cette première zone (A₁).

4. Circuit selon au moins la revendication 1, dans lequel la première capacité de substrat (C₁₁, C₁₂) normée sur l'unité de surface (µm²) est réduite par rapport à la deuxième capacité de substrat (C₂) normée sur l'unité de surface (µm²) en ce que dans la première zone (A₁') du transistor PDMOS (20) le substrat (60') est enlevé.

5. Circuit intégré selon l'une quelconque des revendications précédentes, dans lequel la première zone (A₁, A₁') est une zone de transition d'une cuvette de type n (23) et d'une cuvette de type p (24) du transistor PDMOS (20).

6. Circuit intégré selon l'une quelconque des revendications précédentes, dans lequel une pluralité de transistors PDMOS (20) sont conformés dans la première zone (200) et/ou une pluralité de transistors NDMOS sont conformés dans la deuxième zone (400).

7. Circuit intégré selon l'une quelconque des revendications précédentes, dans lequel la première zone (A₁, A₁', 200) est située à distance de chaque transistor NDMOS (40).

8. Procédé de fabrication d'un circuit intégré, selon lequel :
• on produit un substrat (60, 600, 600'), un diélectrique (50, 500, 550) contigu au substrat (60, 600, 600') et une zone semi-conductrice (700, 700', 800) contiguë au diélectrique (50, 500, 550),
• on conforme au moins un transistor NDMOS (40) dans la zone semi-conductrice (700, 700', 800),
• on conforme au moins un transistor (20) PDMOS dans la zone semi-conductrice (700, 700', 800),
**caractérisé en ce que** :
• pour produire le diélectrique (50, 500, 550), on donne à celui-ci une épaisseur plus importante dans une première zone (A₁) du transistor PDMOS (20) que dans une deuxième zone (A₂) du transistor NDMOS (40).

9. Procédé de fabrication d'un circuit intégré, selon lequel :
. on produit un diélectrique (50') contigu à un substrat (60') et une zone semi-conductrice isolée du substrat (60') par le diélectrique (50'),
. on conforme au moins un transistor NDMOS (40) dans la zone semi-conductrice,
. on conforme au moins un transistor PDMOS (20) dans la zone semi-conductrice,
**caractérisé en ce que** :
. l'on enlève localement, plus particulièrement par gravure, le substrat (60') dans une première zone (A₁') située en-dessous du transistor PDMOS.
